# EUROPEAN PATENT APPLICATION

(11) **EP 4 832 727 A1**
(43) Date of publication of application: **28.10.2026**
(21) Application number: 26174357.9
(22) Date of filing: 24.04.2026
(51) Int. Cl.: H10N 50/10, H10N 50/85, G11C 11/16

(54) **MAGNETIC MEMORY DEVICE HAVING SOT STRUCTURES**

(30) Priority: 25.04.2025 KR 20250054341; 30.07.2025 KR 20250104019
(71) Applicant: Samsung Electronics Co., Ltd., Suwon-si, Gyeonggi-do 16677 (KR); Korea Advanced Institute of Science and Technology, Daejeon (KR)
(72) Inventor: JEONG, Junho, 16677 Suwon-si (KR); PARK, Byong Guk, 34141 Daejeon (KR); SEO, Hyeongjoo, 34141 Daejeon (KR)
(74) Representative: Marks & Clerk LLP

(57) **Abstract**

A magnetic memory device includes a substrate; a spin-orbit torque structure including an antiferromagnetic material layer and a nonmagnetic material layer on the substrate; a magnetic tunnel junction pattern including a free layer, a tunnel barrier and a fixed layer on the spin-orbit torque structure; and a first lower electrode disposed on one side surface of the spin-orbit torque structure and a second lower electrode disposed on the other side surface of the spin-orbit torque structure, wherein a first direction from the first lower electrode to the second lower electrode, parallel to an upper surface of the substrate, has an inclination with a crystal direction of a crystal plane of the antiferromagnetic material layer.

## Description

### FIELD

Example embodiments of the present disclosure relate to a magnetic memory device having spin-orbit torque (SOT) structures.

### BACKGROUND

A magnetic memory device may be a nonvolatile memory device which reads and writes data using a magnetic tunnel junction pattern including two magnetic materials and an insulating layer interposed therebetween. A resistance value of the magnetic tunnel junction pattern may vary depending on a magnetization direction of the two magnetic materials, and data may be programmed or erased using the difference in resistance values. Among such devices, a magnetic memory device using spin-orbit torque (SOT) phenomenon may have advantages such as high switching speed, high durability, and low power consumption as compared to a general Spin-Transfer Torque Magnetic Random Access Memory (STT-MRAM) by switching magnetization of magnetic tunnel junction (MTJ) using a spin-orbit torque.

### SUMMARY

Example embodiments of the present disclosure provide a magnetic memory device which may stably implement magnetization direction switching of a free layer without an external magnetic field. Example embodiments comprise spin-orbit torque magnetic random access memory (SOT MRAM).

According to example embodiments of the present disclosure, a magnetic memory device includes a substrate; a spin-orbit torque structure including an antiferromagnetic material layer and a nonmagnetic material layer on the substrate; a magnetic tunnel junction pattern including a free layer, a tunnel barrier and a fixed layer on the spin-orbit torque structure; and a first lower electrode disposed on one side surface of the spin-orbit torque structure and a second lower electrode disposed on the other side surface of the spin-orbit torque structure, wherein a first direction from the first lower electrode to the second lower electrode, substantially parallel to an upper surface of the substrate, has an inclination with a crystal direction of a crystal plane of the antiferromagnetic material layer.

According to an embodiment, an angle between the first direction D1 and a vector Néel direction of the antiferromagnetic material layer 145 is greater than or equal to 0 degrees and less than or equal to 45 degrees. According to an embodiment, the first direction is aligned with (e.g., is parallel with) the Néel vector direction of the antiferromagnetic material layer 145.

According to example embodiments of the present disclosure, a magnetic memory device includes a substrate; a spin-orbit torque structure including an antiferromagnetic material layer having a first crystal plane on the substrate and a nonmagnetic material layer on the antiferromagnetic material layer, and patterned in a first direction to have a first angle with respect to the first crystal plane; a magnetic tunnel junction pattern including a free layer, a tunnel barrier, and a fixed layer on the spin-orbit torque structure; a first lower electrode and a second lower electrode spaced apart from one another in the first direction and disposed on both side surfaces of the spin-orbit torque structure; and an upper electrode disposed on the magnetic tunnel junction pattern, wherein the first angle is 45 to 90 degrees.

According to example embodiments of the present disclosure, a magnetic memory device includes a metal oxide pattern having a first crystal plane; an antiferromagnetic material layer having the first crystal plane on the metal oxide pattern and extending in a first direction inclined with respect to the first crystal plane; a nonmagnetic material layer extending in the first direction on the antiferromagnetic material layer; a magnetic tunnel junction pattern including a free layer, a tunnel barrier, and a fixed layer on the nonmagnetic material layer; and a first lower electrode and a second lower electrode spaced apart from one another in the first direction, disposed on both side surfaces of the nonmagnetic material layer, respectively, wherein an angle between a direction of the first crystal plane and the first direction ranges from 45 degrees to 90 degrees.

At least some of the above and other features of the invention are set out in the claims.

### BRIEF DESCRIPTION OF DRAWINGS

The above and other aspects, features, and advantages of the present disclosure will be more clearly understood from the following detailed description, taken in combination with the accompanying drawings, in which:
FIG. 1 is a circuit diagram illustrating a cell array of a magnetic memory device according to example embodiments of the present disclosure;
FIG. 2 is a cross-sectional diagram illustrating a magnetic memory device according to example embodiments of the present disclosure;
FIG. 3 is a perspective diagram illustrating a magnetic memory device according to example embodiments of the present disclosure;
FIG. 4 is a cross-sectional diagram illustrating a magnetic memory device according to example embodiments of the present disclosure, illustrating spin-orbit torque;
FIG. 5A is a graph indicating a crystal plane of a magnetic memory device in FIG. 4, and FIG. 5B is a graph indicating switching properties depending on an azimuth;
FIGS. 6A, 6B, and 6C are graphs indicating switching properties of the magnetic memory device in FIG. 4;
FIGS. 7A and 7B are a cross-sectional diagram illustrating a magnetic memory device according to example embodiments of the present disclosure, and a graph indicating switching properties;
FIGS. 8A and 8B are a cross-sectional diagram illustrating a magnetic memory device according to comparative example 1, and a graph indicating switching properties;
FIGS. 9A and 9B are a cross-sectional diagram illustrating a magnetic memory device according to comparative example 2, and a graph indicating switching properties;
FIGS. 10 and 11 are cross-sectional diagrams illustrating a magnetic memory device according to example embodiments of the present disclosure;
FIGS. 12A, 12B, 12C, and 12D are cross-sectional diagrams illustrating a method of manufacturing a magnetic memory device in FIG. 2 according to example embodiments of the present disclosure; and
FIGS. 13 and 14 are block diagrams illustrating an electronic device including a magnetic memory device according to example embodiments of the present disclosure.

### DETAILED DESCRIPTION

Hereinafter, embodiments of the present disclosure will be described as follows with reference to the accompanying drawings.

Example embodiments of the present disclosure may be modified in various other forms or various example embodiments may be combined, and the scope of the present disclosure is not limited to the example embodiments described below. Also, example embodiments may be provided to more completely describe the present disclosure to a person skilled in the art. Thus, the shape and size of the elements in the drawings may be exaggerated for clearer description, and elements indicated by the same reference numerals in the drawings may be the same elements.

The example embodiments are not limited to the illustrated examples, and may also include variations in shape formed depending on manufacturing processes. For example, an etched area illustrated as being perpendicular may be rounded or may have a shape having a predetermined curvature. Accordingly, the regions illustrated in the drawings may be schematic, and the shapes of the regions illustrated in the drawings are intended to illustrate specific shapes of regions of the device and are not intended to limit the scope of the present disclosure.

Unless otherwise indicated, in example embodiments, terms such as "on," "upper surface," "below," "lower surface," "upward direction," "downward direction," "lateral surface," "high" and "low" are based on the drawings and may actually vary depending on the direction in which a memory element is disposed. For instance, a vertical direction may be defined perpendicular to an upper surface of a substrate upon which the memory element (e.g., a spin-orbit torque structure and a magnetic tunnel junction pattern) is disposed. Terms such as "on", "upper surface", below," "lower surface," "upward direction," "downward direction", "high" and "low" may be defined relative to this vertical direction. It will be appreciated that the directions and positions defined herein are defined relative to the structure of the magnetic memory device, and therefore need not imply any particular orientation of the magnetic memory device in use. The Terms "on" and "under" may include forming elements "directly", or forming elements "indirectly" with another component interposed therebetween.

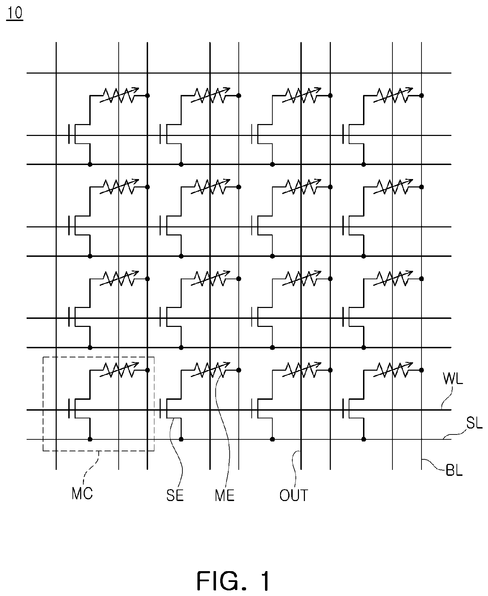

FIG. 1 is a circuit diagram illustrating a cell array of a magnetic memory device according to example embodiments.

Referring to FIG. 1, an array cell of a magnetic memory device 10 may include unit cells MC of the magnetic memory device 10 arranged in a matrix form. The unit cells MC of the magnetic memory device 10 may include a select element SE and a magnetic memory device ME. The unit cells MC of the magnetic memory device may be electrically connected to the wordline WL and the bitline BL.

Also, when the select element SE is a transistor as illustrated in FIG. 1, a source line SL electrically connected to a source region of the select element SE may be further included. A wordline WL and a bitline BL may be two-dimensionally arranged at a predetermined angle, for example, vertically. Also, the wordline WL and the source line SL may be arranged at a predetermined angle, for example, parallel to one another.

The select element SE may be configured to selectively control a flow of charge crossing a magnetic tunnel junction. For example, the select element SE may be one of a diode, a PNP bipolar transistor, an NPN bipolar transistor, an NMOS field effect transistor, and a PMOS field effect transistor.

In FIG. 1, each of the unit cells MC is illustrated as including a select element SE and a magnetic memory device ME, but example embodiments thereof are not limited thereto. Two select elements may be included to distinguish operations of reading and writing data, and/or a diode disposed at an output terminal may be further included.

The magnetic memory device ME may include a magnetic tunnel junction (MTJ) pattern. The magnetic memory device ME may include a spin-orbit torque (SOT) structure. The SOT structure may generate spin-orbit torque (SOT) in a free layer of the magnetic tunnel junction pattern 150, thereby switching a magnetization direction of the free layer. By switching the magnetization direction of the free layer, a memory function may be performed as a variable resistor in which resistance of the magnetic tunnel junction pattern changes.

In order to generate spin-orbit torque in the SOT structure of the magnetic memory device ME, a weak input critical current may be transferred through the select element SE, and an input critical current may flow through the output line OUT. Accordingly, the magnetic memory device ME may be understood as an element connected to three terminals of the select element SE, the output line OUT, and the bitline BL. The output line OUT may be grounded as the source line SL, but example embodiments thereof are not limited thereto, and a voltage of a level for allowing an input critical current to flow may be configured.

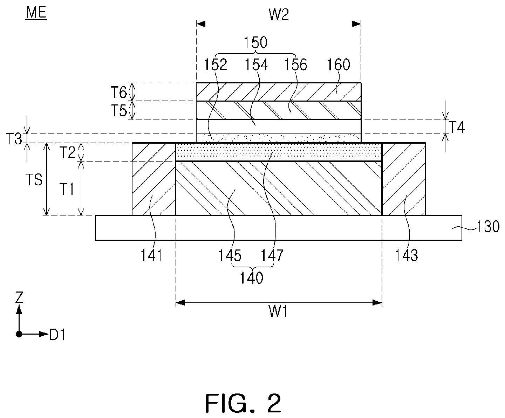

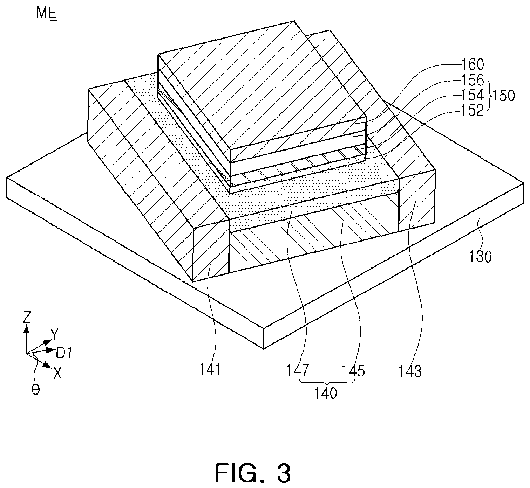

FIG. 2 is a cross-sectional diagram illustrating a magnetic memory device according to example embodiments. FIG. 3 is a perspective diagram illustrating a magnetic memory device according to example embodiments.

Referring to FIGS. 2 and 3, a magnetic memory device ME disposed in each of the unit cells MC may be implemented as a single unit.

Specifically, the magnetic memory device ME may include a substrate 130, a SOT structure 140 disposed on an upper surface of the substrate 130, and a magnetic tunnel junction pattern 150 disposed on the SOT structure 140 (e.g., on an upper surface of the SOT structure 140).

A first lower electrode 141 and a second lower electrode 143 may be disposed on both side surfaces of a SOT structure 140, and an upper electrode 160 in contact with a magnetic tunnel junction pattern 150 may be disposed.

The substrate 130 may be an insulating structure including an oxide, for example, metal oxide. Specifically, the substrate 130 may include cobalt oxide (CoOx), iron oxide (FeOx), nickel oxide (NiOx), magnesium oxide (MgOx), aluminum oxide (AlOx), tantalum oxide (TaOx), or zirconium oxide (ZrOx). The materials may be used alone or by stacking two or more materials. In this case, the substrate 130 may be disposed to have a (110) crystal plane. For example, by including magnesium oxide (MgOx), an upper surface of the substrate 130 may include a (110) crystal plane. Here, (110) denotes a Miller index indicating a crystallographic plane. A material that is said to "have" a (110) crystal plane may have a surface (e.g., an upper surface) that runs parallel to the (110) crystal plane. A surface that "includes" a (110) crystal plane may run parallel to the (110) crystal plane. Also, example embodiments are merely an example, and the substrate 130 may include various crystal planes such as (100), (111), (101), (112), or the like.

The SOT structure 140 may be disposed on the substrate 130. The SOT structure 140 may include an antiferromagnetic material layer 145 and a nonmagnetic material layer 147 stacked in order in a Z-direction on an upper surface of the substrate 130. The Z-direction may be perpendicular to the upper surface of the substrate 130. The Z-direction may be a vertical direction of the magnetic memory device. The upper surface of the substrate 130 may be parallel to an X-direction and a Y-direction. The terms "X", "Y" and "Z" are merely labels, and may be replaced with each other, or may be replaced with numerical labels, such as "first", "second" and "third".

When a crystal direction of the (110) crystal plane of the substrate 130 is aligned with the X-direction on a plane formed by the X-direction and the Y-direction, the SOT structure 140 may be patterned to have a first angle θ with respect to the X-direction. That is, when the X-direction is configured along the crystal direction of the (110) crystal plane of the substrate 130, the SOT structure 140 may be a stack structure patterned to extend in a D1 direction inclined at a first angle θ with respect to (e.g., relative to) the X-direction. The term "D1" is merely a label, and may be replaced with another label, such as a numerical label (e.g., "a first direction").

Accordingly, the SOT structure 140 may be disposed to have an inclination of (e.g., to be inclined or angled by) a first angle θ with respect to (e.g., relative to) the crystal direction of the (110) crystal plane of the substrate 130. In example embodiments, "having an inclination" may be defined as not being parallel to the reference X-direction and extending in the D1 direction having an inclination of 45° to 90°, the first angle θ, with respect to the X-direction on the X-Y plane. For instance, the first angle may be greater than or equal to 45° and less than or equal to 90°.

The SOT structure 140 may have a polygonal shape, for example, a quadrangular shape, having a first width W1 in the D1 direction on the X-Y plane.

The antiferromagnetic material layer 145 on the substrate 130 may be defined as a ferromagnetic material in which adjacent magnetic moments are aligned antiparallel to one another, such that the total magnetic moments cancel one another out and converge to zero. The antiferromagnetic material layer 145 may include a metal oxide such as NiO, CoO, or MnO. For example, the antiferromagnetic material layer 145 of the SOT structure 140 may include nickel oxide (NiO), and when the antiferromagnetic material layer 145 of nickel oxide (NiO) is deposited on a magnesium oxide (MgO) substrate 130, a crystal plane of nickel oxide (NiO) may be formed along the (110) crystal plane of the magnesium oxide (MgO), such that the antiferromagnetic material layer 145 may also be deposited to have a (110) crystal plane. Accordingly, the crystal planes of the substrate 130 and the antiferromagnetic material layer 145 may be the same.

The antiferromagnetic material layer 145 may have a first thickness T1, and the first thickness T1 may be 25 nm to 50 nm, and preferably 25 nm to 35 nm. For instance, the first thickness may be greater than or equal to 25nm and less than or equal to 50nm. For instance, the first thickness may be greater than or equal to 25nm and less than or equal to 35 nm.

A nonmagnetic material layer 147 may be disposed on the antiferromagnetic material layer 145.

The nonmagnetic material layer 147 may include a material hardly affected by an external magnetic field and not exhibiting magnetism, and representative examples thereof may include tantalum (Ta), platinum (Pt), tungsten (W), iridium (Ir), hafnium (Hf), or ruthenium (Ru). A nonmagnetic material may be that the material exhibits no perceptible attraction to a permanent magnet and does not retain residual magnetization in the absence of an external magnetic field. A nonmagnetic material may be a material characterized by a relative magnetic permeability (*µᵣ*) that is substantially equal to 1. For instance, a nonmagnetic material may be a material with a relative magnetic permeability (*µᵣ*) of less than 1.05, preferably less than 1.01, when measured at 20°C. The nonmagnetic material layer 147 may have a lower surface in direct contact with an upper surface of the antiferromagnetic material layer 145, and an upper surface may be in direct contact with a free layer 152 of the magnetic tunnel junction pattern 150. In this case, "being in contact with" may be understood as being directly in contact with without any layer interposed therebetween so as to have an indirect interfacial surface.

The nonmagnetic material layer 147 may have a second thickness T2 less than the first thickness T1 of the antiferromagnetic material layer 145, and the second thickness T2 may be 1/8 to 1/10 of the first thickness T1. For example, the second thickness T2 may be 3 nm to 4 nm (e.g., greater than or equal to 3nm and less than or equal to 4nm), and when the first thickness T1 is 30 nm, the second thickness T2 may be 3.5 nm. Accordingly, the thickness Ts of the SOT structure 140 may be generally determined by the antiferromagnetic material layer 145. The thicknesses discussed herein may be measured in the Z-direction.

The nonmagnetic material layer 147 may have the same area as the antiferromagnetic material layer 145, and may have a side surface aligned with a side surface of the antiferromagnetic material layer 145 in the Z-direction. Accordingly, the nonmagnetic material layer 147 may have a polygonal shape, for example, a quadrangular shape, having the first width W1 in the D1 direction.

A magnetic tunnel junction pattern 150 may be disposed on the nonmagnetic material layer 147.

The magnetic tunnel junction pattern 150 may be a stack structure in which a tunnel barrier 154 is disposed between a free layer 152 and a fixed layer 156. In the magnetic memory device ME in example embodiments, the free layer 152 may be disposed on the SOT structure 140. Accordingly, the free layer 152 may be disposed on the nonmagnetic material layer 147.

The free layer 152 may include a perpendicular magnetization ferromagnetic material. In this context, perpendicular magnetization may refer to magnetization that is aligned perpendicular to the surface (e.g., upper surface) of the material. This may be known as perpendicular magnetic anisotropy. Perpendicular magnetization may refer to a structure that has a magnetic easy axis that is perpendicular to the surface (e.g., upper surface) of the material. The easy axis may be the axis along which saturation magnetization is achieved with the lowest applied magnetic field. The magnetization direction of the free layer 152 may be variable. That is, the magnetization direction of the free layer 152 may be changed/switched by spin-orbit torque applied to the free layer 152. For instance, the magnetization direction of the free layer 152 may be changed between a first direction parallel to the Z-direction and a second direction antiparallel to the Z-direction.

By allowing a spin-polarized current to pass through the free layer 152, the magnetization direction may be changed, such that data may be written. That is, when a current is applied to the SOT structure 140, the spin current generated by the spin Hall effect of the nonmagnetic material layer 147 may excite the magnetization of the antiferromagnetic material layer 145, and accordingly, a third spin current may be generated, and this spin current may transfer a spin component in the vertical direction to the free layer 152, enabling field-free magnetization switching. That is, the magnetization switching of the free layer 152 may be performed without an external magnetic field.

When the SOT structure 140 has a stack structure of the antiferromagnetic material layer 145 and the nonmagnetic material layer 147, a larger spin current may be induced, such that magnetization switching of the free layer 152 may be induced at a low critical current.

The free layer 152 may include at least one selected from a ferromagnetic material group consisting of cobalt (Co), iron (Fe), nickel (Ni), palladium (Pd), and platinum (Pt). The free layer 152 may further include boron (B), silicon (Si), or zirconium (Zr). These materials may be used alone or in combination of two or more. For example, the free layer 152 may include a composite material such as CoFe, NiFe, FeCr, CoFeNi, PtCr, CoCrPt, CoFeB, NiFeSiB, CoFeSiB, or the like. Preferably, the free layer 152 may include CoFeB and may have a third thickness T3 less than the second thickness T2. When the second thickness T2 is 3 nm to 4 nm, the third thickness T3 may be 1 nm to 2 nm (e.g., greater than or equal to 1 nm and less than or equal to 2 nm), for example, 1.4 nm.

A tunnel barrier 154 may be disposed on the free layer 152. The tunnel barrier 154 may include a material selected from a group consisting of magnesium oxide (MgO), aluminum oxide (Al₂O₃), silicon oxide (SiO₂) and boron oxide (B₂O₃), and preferably, magnesium oxide (MgO). The tunnel barrier 154 may have a fourth thickness T4 greater than a third thickness T3, but example embodiments thereof are not limited thereto. When the third thickness T3 is 1.4 nm, the fourth thickness T4 may be 2 nm to 2.5 nm (e.g., greater than or equal to 2 nm and less than or equal to 2.5 nm), for example, 2 nm.

A fixed layer 156 may be disposed on the tunnel barrier 154. The fixed layer 156 may include a perpendicular magnetization ferromagnetic material. The magnetization direction of the fixed layer 156 may be a vertical direction (e.g., the Z-direction). The magnetization direction of the fixed layer 156 may not be changed by a current flowing through the magnetic tunnel junction structure 150 and may be fixed in one direction.

The fixed layer 156 may include a fixed pattern, a lower ferromagnetic pattern, an antiferromagnetic coupling spacer pattern, and an upper ferromagnetic pattern. In this case, the fixed pattern may be formed to include, for example, manganese iron (FeMn), manganese iridium (IrMn), manganese platinum (PtMn), manganese oxide (MnO), manganese sulfide (MnS), tellurmanganese (MnTe), manganese fluoride (MnF2), iron fluoride (FeF2), iron chloride (FeCl2), iron oxide (FeO), cobalt chloride (CoCl2), cobalt oxide (CoO), nickel chloride (NiCl2), nickel oxide (NiO), chromium (Cr), or the like. The upper and lower ferromagnetic patterns may be formed to include, for example, a ferromagnetic material including at least one of iron (Fe), nickel (Ni), and cobalt (Co). The antiferromagnetic coupling spacer pattern may be formed to include, for example, at least one of ruthenium (Ru), iridium (Ir), or rhodium (Rh).

An upper electrode 160 may be disposed on the magnetic tunnel junction pattern 150. The upper electrode 160 may have a thickness T6 greater than a thickness of the fixed layer 156 and may include a single layer or multiple layers of a conductive material such as titanium (Ti), tantalum (Ta), ruthenium (Ru), titanium nitride (TiN), tantalum nitride (TaN), or tungsten (W).

The magnetic tunnel junction pattern 150 on the SOT structure 140 may be patterned to have a second width W2 less than the first width W1 in the D1 direction on the SOT structure 140. However, a center of the first width W1 and a center of the second width W2 may be coaxial in the D1 direction. For instance, a center of the first width W1 and a center of the second width W2 may overlap (e.g., may be aligned) in the Z-direction.

In the SOT structure 140, the first lower electrode 141 and the second lower electrode 143 may be disposed on both side surfaces opposing in the D1 direction.

The first lower electrode 141 and the second lower electrode 143 may be spaced apart from one another (e.g., in the D1 direction). The first lower electrode 141 may be connected to the select element SE, and the second lower electrode 143 may be connected to the output line OUT.

By flowing a critical current Iin from the first lower electrode 141 to the second lower electrode 143 through the SOT structure 140, the magnetization direction of the free layer 152 may be changed.

To this end, the first lower electrode 141 may be disposed so as to be in contact with one side surface of the SOT structure 140, and may be disposed so as to be in contact with the antiferromagnetic material layer 145 and the nonmagnetic material layer 147 on the substrate 130 simultaneously. The second lower electrode 143 may be in contact with the other side surface of the SOT structure 140, and may be in contact with the antiferromagnetic material layer 145 and the nonmagnetic material layer 147 on the substrate 130 simultaneously. When a conceptual line extending in the D1 direction crossing the SOT structure 140 from the first lower electrode 141 to the second lower electrode 143 extends, the critical current Iin may flow with an inclination at the first angle θ with respect to the (110) crystal plane of the substrate 130, that is, the crystal plane of the antiferromagnetic material layer 145.

In this way, when the SOT structure 140 in the magnetic memory device ME is disposed so as to be inclined toward the first angle θ with respect to the crystal plane of the substrate 130, that is, the crystal plane of the antiferromagnetic material layer 145, the induced spin torque may be maximized.

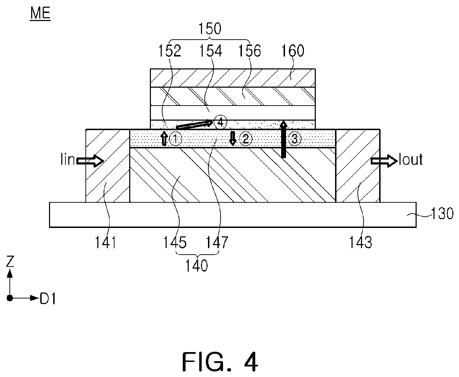

Hereinafter, the magnetization phenomenon of the free layer 152 of the magnetic memory device ME may be described with reference to FIG. 4.

Referring to FIG. 4, when a critical current Iin, that is, a current of a small value, flows to the first lower electrode 141 of the magnetic memory device ME in FIG. 2, a spin current may be generated in the nonmagnetic material layer 147.

The nonmagnetic material layer 147 may be a material having a large spin-orbit interaction. When the critical current Iin is applied in-plane, a spin current J of the nonmagnetic material layer 147 may include a first spin current ① flowing to the upper free layer 152 and a second spin current ② flowing to the lower antiferromagnetic material layer 145.

In this case, when the second spin current ② flows into the antiferromagnetic material layer 145, the second spin current ② may interact with magnetization of the antiferromagnetic material layer 145, and a spin torque may be applied, such that spin pumping which excites antiferromagnetic magnetization may occur. By the spin pumping, a third spin current ③ may be generated. The third spin current ③ may pass from the antiferromagnetic layer 145, through the nonmagnetic layer 147, to the free layer 152. The spin polarization of the third spin current ③ may be determined by a Néel vector of the antiferromagnetic material layer 145. That is, when the Néel vector of the antiferromagnetic material layer 145 has a vertical component and the first angle θ is not parallel to the critical current Iin direction, the third spin current ③ having vertical spin polarization may be generated.

The third spin current ③ generated as above may have vertical spin polarization, such that, when transferred to the free layer 152, the magnetization of the free layer 152 may be switched. Accordingly, when switching the magnetization of the free layer 152, spin polarization may be used to enable the switching without an external magnetic field, such that data may be read or written.

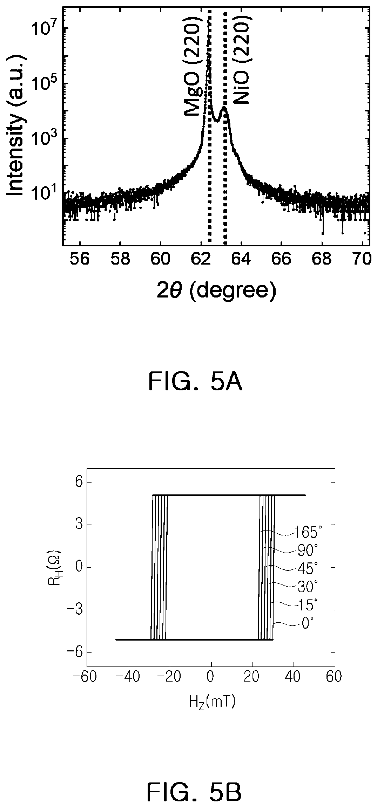

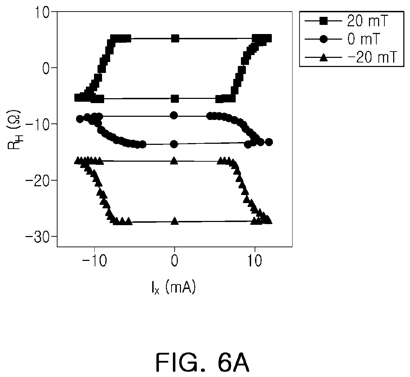

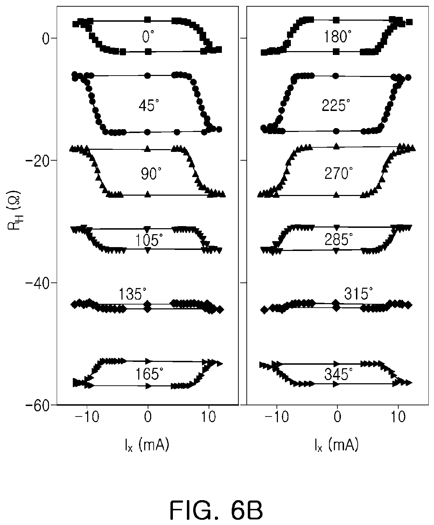

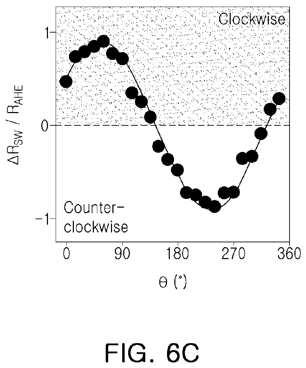

In the description below, the properties of the magnetic memory device ME according to example embodiments will be described with reference to FIGS. 5A, 6A, 6B, and 6C.

FIG. 5A is a graph indicating a crystal plane of a magnetic memory device in FIG. 4, and FIG. 5B is a graph indicating switching properties depending on an azimuth.

FIG. 5A illustrates crystal planes of a substrate 130 and an antiferromagnetic material layer 145 when a substrate 130 includes MgO and an antiferromagnetic material layer 145 of NiO is deposited on the substrate 130 in a magnetic memory device ME in example embodiments.

As example embodiments, in the magnetic memory device ME, an insulating material, NiO, was deposited to a thickness of 30 nm as an antiferromagnetic material layer 145 on the substrate 130 of a (110) crystal plane including MgO by sputtering, and was heat-treated at 800°C to increase crystallinity. As in in FIG. 5A, by analysis of X-ray diffraction spectroscopic data, it was confirmed that the deposited NiO layer had a (110) crystal plane as the MgO layer.

In this case, as in FIGS. 2 and 3, the magnetization properties were confirmed to determine whether the device was able to function as a magnetic memory device ME depending on the first angle θ when an arbitrary crystal direction (e.g., [-110] direction) in the (110) crystal plane was configured as the X-direction, and the SOT structure 140 and the magnetic tunnel junction pattern 150 are patterned by tilting on the crystal plane at the first angle θ. That is, the patterning angle, the critical current Iin flow direction, which is a conceptual line connecting the first lower electrode 141 to the second lower electrode 143 was defined as the D1 direction, and when the crystal plane was configured in the X-direction, the angle between the X-direction and the D1 direction was defined as the first angle θ. It was confirmed whether the magnetic memory device ME in FIGS. 2 and 3 was able to operate as a memory device, that is, whether magnetization switching is possible, depending on the first angle θ.

Referring to FIG. 5B, when magnetic switching is performed in a state in which an external magnetic field is applied (X-axis: magnitude of external magnetic field), the device may be considered applicable as a memory device, and when whether switching was performed was observed while tilting the first angle θ from 0 degrees to 165 degrees in 15-degree intervals, as a result of measuring abnormal Hall resistance R_{H}, a vertical magnetic anisotropy was obtained regardless of the first angle θ at all angles of the sample, and the magnetic properties (RH) were switched similarly. Accordingly, it is indicated that the device may sufficiently function as the magnetic memory device ME in a state in which an external magnetic field is applied.

FIGS. 6A, 6B, and 6C are graphs indicating switching properties of the magnetic memory device in FIG. 4.

FIG. 6A relates to analysis of switching behavior of the magnetic memory device ME depending on the presence of an external magnetic field after the SOT structure 140 and the free layer 152 of the magnetic memory device ME in FIGS. 2 to 4 were implemented by configuring the antiferromagnetic material layer/nonmagnetic material layer/free layer/tunnel barrier with NiO (30 nm)/Ta (3.5 nm)/CoFeB (1.4 nm)/MgO (2 nm). In this case, a pulse current of a width of 50 µs was applied as a switching current (I_{X}), and as for the switching properties of the magnetization, abnormal Hall resistance R_{H} was measured by applying a read current of 0.1 mA.

In this case, with respect to the first angle θ as a reference, the switching behavior was measured by varying the switching current (IX) of the magnetic memory device ME from (+) to (-) and from (-) to (+).

In FIG. 6A, it was confirmed that, when an in-plane magnetic field (±20 mT) was applied parallel to the direction of the switching current (IX), the magnetization direction was completely switched from the +Z- direction to the -Z-direction (a switching ratio of 100%), and the switching direction was reversed according to an external magnetic field. In this case, when the switching current (IX) was applied in a no-magnetic field state without applying an external magnetic field, the magnetization switching behavior was exhibited, but the switching ratio was low, approximately 50%. Accordingly, when the first angle θ was 0 degrees, the switching ratio was low in the absence of an external magnetic field.

In this case, as in FIG. 6B, in a no-magnetic-field state (0 mT) without an external magnetic field applied, the switching properties of magnetization were examined while tilting the first angle θ from 0 degrees to a predetermined angle, and it was confirmed that the switching ratio varied depending on the first angle θ.

That is, when the first angle θ was 0 degrees, as indicated in FIG. 6A, the switching ratio was confirmed to be approximately 50% in FIG. 6B as well. When the first angle θ was approximately 45 degrees, the switching ratio reached almost 100%, and when up to about 90 degrees, the switching ratio was within the range usable as the magnetic memory device ME. When greater than 90 degrees, the switching ratio significantly decreased, and when 135 degrees, no magnetic-field switching occurred.

Accordingly, in a magnetic field-free state, when the first angle θ is between 45 and 90 degrees (e.g., greater than or equal to 45 degrees and less than or equal to 90 degrees), the switching properties usable as the magnetic memory device ME may be exhibited.

The switching ratio for the angle is illustrated in FIG. 6C. In FIG. 6C, the switching ratio (R_{SW}/R_{AHE}) according to the first angle θ is indicated. R_{AHE} is the resistance component arising from the anomalous Hall effect, which is proportional to the out-of-plane magnetization of the material. It is typically defined as the full Hall resistance difference between the positive and negative magnetic saturation states. R_{SW} is the change in anomalous Hall resistance induced by an external switching stimulus (such as a current pulse or spin-orbit torque), representing the portion of magnetization that has been reversed or switched. The switching ratio (R_{SW}/R_{AHE}) represents the fraction of the total anomalous Hall signal that is changed by the switching process. It corresponds to the proportion of the magnetic volume (or domain fraction) that has been switched relative to full magnetization reversal. In a magnetic field-free state, the switching ratio (R_{SW}/R_{AHE}) of the magnetic memory device ME exhibited a dependence on the first angle θ as a cosine function, and the switching ratio (R_{SW}/R_{AHE}) of magnetization was maximum when the first angle θ was around 50 degrees, which may be exhibited similarly at around 220 degrees depending on a cosine function.

This dependence on the first angle θ may be based on the notion that the angle of the Néel vector, which is a regular variable of the antiferromagnetic material layer 145, was approximately 55 degrees when NiO, which is the antiferromagnetic material layer 145, grew to a (110) plane. The angle of the Néel vector of the antiferromagnetic material layer 145 matched the angle at which the switching ratio (R_{SW}/R_{AHE}) in the field-free state was maximum, and the field-free switching behavior of the magnetic memory device ME in FIGS. 2, 3 and 4 became greater when the Néel vector direction of the antiferromagnetic material layer 145 and the first angle θ were close. According to specific embodiments, the first direction D1 may be aligned with the Néel vector direction of the antiferromagnetic material layer 145. According to an embodiment, an angle between the first direction D1 and the Néel vector direction of the antiferromagnetic material layer 145 is greater than or equal to 0 degrees and less than or equal to 45 degrees.

That is, by the current applied to the magnetic memory device ME, a first spin current ① and a second spin current ② may be generated by the spin Hall effect of Ta, the nonmagnetic material layer 147, and the first spin current ① may apply spin-orbit torque to the free layer 152 having CoFeB, as a ferromagnetic material. However, in this case, as the spin polarization is positioned within the plane, an external magnetic field may be required for switching.

In this case, the second spin current ② may generate a third spin current ③ by spin-pumping NiO, the antiferromagnetic material layer 145, such that spin-orbit torque may be applied to the free layer 152 having CoFeB, as a ferromagnetic material. In the case of the third spin current ③, the spin polarization may have a vertical component by being dependent on the Néel vector direction of the antiferromagnetic material, such that magnetization switching of the free layer 152 may be carried out without an external magnetic field.

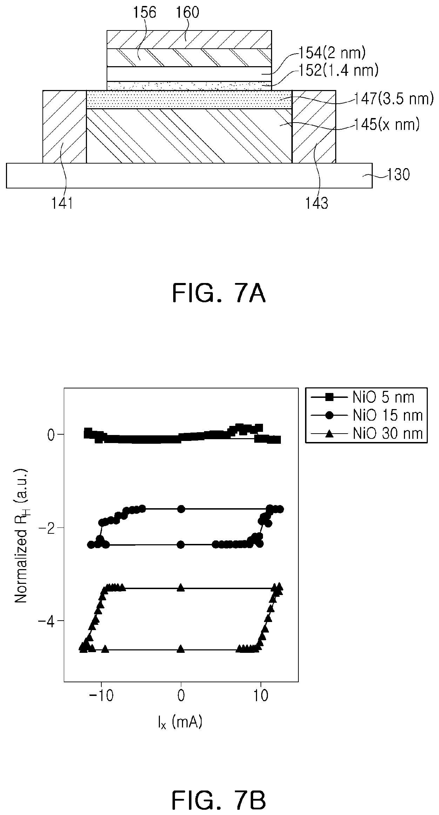

Hereinafter, a magnetic memory device of example embodiments may be described with reference to FIGS. 7A, 7B, 8A, 8B, 9A, and 9B.

FIGS. 7A and 7B are a cross-sectional diagram illustrating a magnetic memory device according to example embodiments of the present disclosure, and a graph indicating switching properties.

The example in FIG. 7A may have the same layer structure as the magnetic memory device ME of example embodiments in FIGS. 2 to 4, and FIG. 7A indicates analysis of magnetization switching properties while varying a thickness of the antiferromagnetic material layer 145.

In FIG. 7A, the SOT structure and the free layer of the magnetic memory device ME in FIGS. 2 to 4 were implemented by configuring the antiferromagnetic material layer/nonmagnetic material layer/free layer/tunnel barrier as NiO (x nm)/Ta (3.5 nm)/CoFeB (1.4 nm)/MgO (2 nm).

In this case, the thickness (x nm) of NiO, the antiferromagnetic material layer 145, was reduced to 5 nm and 15 nm, and was compared with the magnetic memory device ME of example embodiments in which the thickness was implemented to be 30 nm, and the results were indicated in FIG. 7B.

Referring to FIG. 7B, when the NiO thickness (x nm) of the antiferromagnetic material layer 145 was reduced in a non-magnetic field state, the non-magnetic field switching ratio decreased, and non-magnetic field switching was impossible at 5 nm. As the switching ratio was relatively low even at 15 nm, the NiO of the antiferromagnetic material layer 145 may be required to have a thickness of 30 nm or more to exhibit non-magnetic field switching properties.

When the NiO of the antiferromagnetic material layer 145 has a thickness less than 30 nm, the magnetization regularity may be low, such that the antiferromagnetic material properties may degrade, and the switching properties may not be exhibited. When the thickness of NiO, the antiferromagnetic material layer 145, becomes 50 nm or more, roughness of the interfacial surface may increase, which may reduce the vertical anisotropy deposited thereon. Accordingly, the first thickness T1 of the antiferromagnetic material layer 145 may satisfy 30 nm or more and 45 nm or less (e.g., greater than or equal to 30 nm and less than or equal to 45 nm).

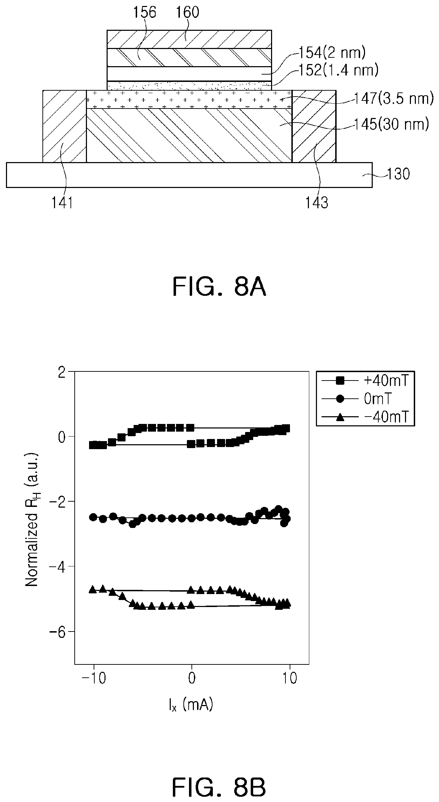

FIGS. 8A and 8B are a cross-sectional diagram illustrating a magnetic memory device according to comparative example 1, and a graph indicating switching properties.

Referring to FIG. 8A, as comparative example 1, titanium (Ti), which has a small spin-orbit interaction, was applied to the nonmagnetic material layer 147 of the magnetic memory device ME in FIG. 2, and the manufacturing was performed under the same thickness and first angle θ conditions as the magnetic memory device in FIG. 2.

The switching results due to spin-orbit torque of NiO (30 nm)/Ti (3.5 nm)/CoFeB (1.4 nm)/MgO (2 nm)/Ta elements of comparative example 1 are indicated in FIG. 8B. In FIG. 8B, even when an external magnetic field is applied (+/-40 mT), the SOT switching ratio was approximately 40%, and magnetization did not switch in the magnetic field-free state, which confirms that the spin current J generated from Ti was significantly less than that from Ta, and thus, spin-orbit torque was not sufficiently generated.

That is, to generate spin pumping of the antiferromagnetic material layer 145 required for magnetic field switching, the nonmagnetic material layer 147 having a large spin-orbit interaction, which may generate sufficient spin current, may be required. Spin-orbit interaction is an interaction where an electron's spin is strongly linked to its motion around the nucleus. If the spin-orbit interaction is large, electric current can be efficiently converted into spin current.

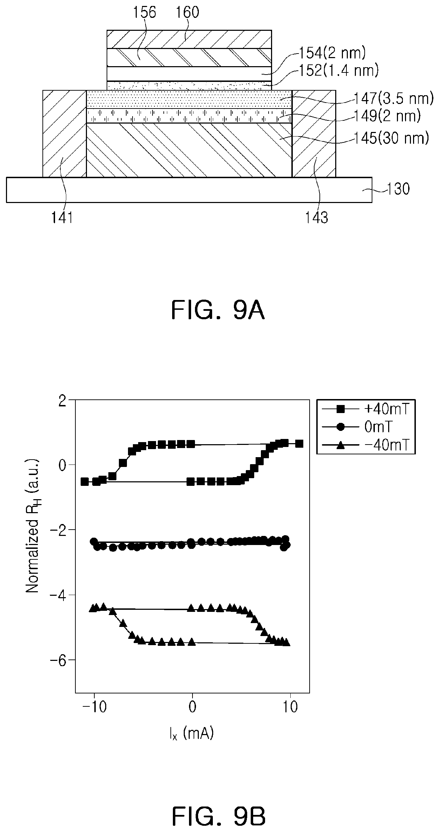

FIGS. 9A and 9B are a cross-sectional diagram illustrating a magnetic memory device according to comparative example 2, and a graph indicating switching properties.

Referring to FIG. 9A, as comparative example 2, the role of the interfacial surface was confirmed by inserting MgO, the insulating layer 149, by a thickness of 2 nm between NiO, the antiferromagnetic material layer 145, and tantalum (Ta), the nonmagnetic material layer 147, in the magnetic memory device ME in FIG. 2.

Referring to FIG. 9B, in the magnetic memory device ME of comparative example 2, as a result of spin-orbit torque switching, spin-orbit torque switching occurred when an external magnetic field was present, but this may be switching of magnetization of the free layer 152 by the first spin current ① generated in tantalum (Ta), the nonmagnetic material layer 147.

In comparative example 2, field-free switching was impossible when no external magnetic field was present, which may because the second spin current ② generated in tantalum (Ta) by the MgO insulating layer 149 did not reach NiO, the antiferromagnetic material layer 145. In other words, for field-free switching, the second spin current② generated in tantalum (Ta) may need to induce spin pumping of NiO, the antiferromagnetic material layer 145.

As described above, to obtain field-free switching in an element based on the antiferromagnetic material layer 145 of example embodiments, a spin current of sufficient magnitude may need to be generated in the nonmagnetic material layer 147, and this spin current may need to induce spin pumping of the antiferromagnetic material layer 145, which may be based on the first angle θ of the layer structure and the spin-orbit torque structure of example embodiments, the thickness of the antiferromagnetic material layer 145, and the material properties of the nonmagnetic material layer 147 as indicated in FIGS. 2, 3, 4, 5A, 6A, 6B, 6C, 7A, and 7B. Also, direct bonding between the antiferromagnetic material layer 145 and the nonmagnetic material layer 147 may also be important properties.

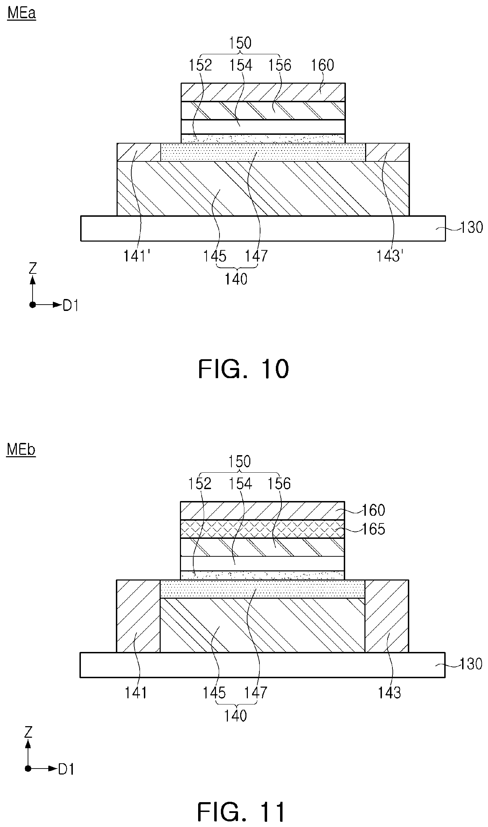

FIGS. 10 and 11 are cross-sectional diagrams illustrating a magnetic memory device according to other example embodiments.

The magnetic memory device MEa in FIG. 10 may be the same as the magnetic memory device ME in FIGS. 2 to 4, other than the shapes of the first lower electrode 141 and the second lower electrode 143.

The magnetic memory device MEa in FIG. 10 may be disposed such that the first and second lower electrodes 141' and 143' may be bonded to one another only on a side surface of the nonmagnetic material layer 147.

Specifically, the first and second lower electrodes 141' and 143' may be disposed on the upper surface of the antiferromagnetic material layer 145, and may be disposed on one side surface and the other side surface of the nonmagnetic material layer 147, respectively. In this case, the first and second lower electrodes 141' and 143' and the antiferromagnetic material layer 145 may be insulated from one another by an insulating structure.

By allowing the first and second lower electrodes 141' and 143' to flow current only to the nonmagnetic material layer 147, the spin current of the nonmagnetic material layer 147 may be further amplified.

The magnetic memory device MEb in FIG. 11 may further include a capping layer 165 between the magnetic tunnel junction pattern 150 and the upper electrode 160.

The capping layer 165 may include a conductive material and a material different from that of the upper electrode 160. For example, when the upper electrode 160 includes tungsten (W), the capping layer 165 may include titanium nitride (TiN) or tantalum nitride (TaN).

The capping layer 165 may have a thickness less than the upper electrode 160, and a side surface thereof may have an inclination continuously with the magnetic tunnel junction pattern 150 and the upper electrode 160 above and below the side surface.

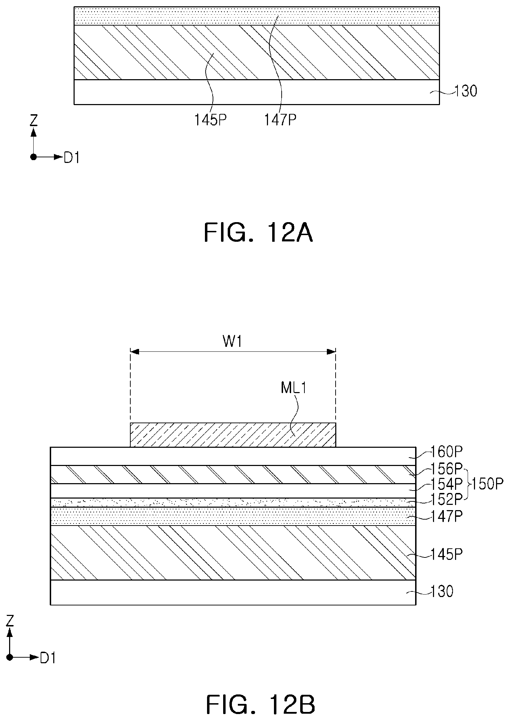

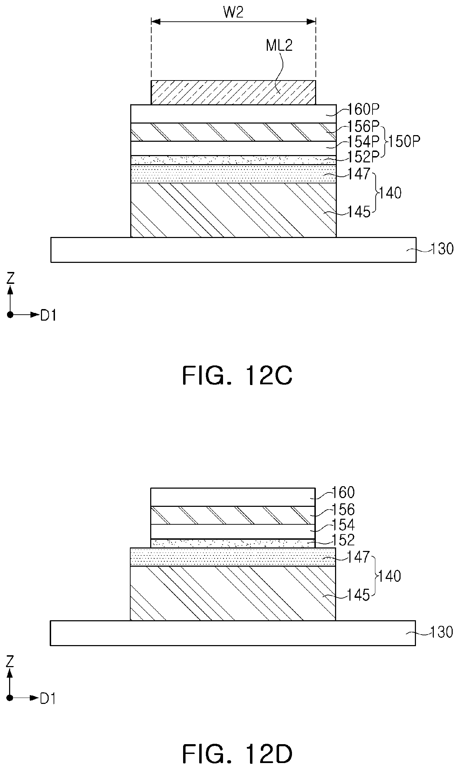

Hereinafter, a method of manufacturing a magnetic memory device in FIG. 2 will be described with reference to FIGS. 12A, 12B, 12C, and 12D.

Referring to FIG. 12A, a preliminary antiferromagnetic material layer 145P and a preliminary nonmagnetic material layer 147P may be formed on a substrate 130.

The substrate 130 may be an insulating structure, and an insulating substrate 130 including magnesium oxide (MgO) may be prepared. The substrate 130 may be grown to have a (110) crystal plane on a surface thereof.

NiO may be sputtered to the (110) crystal plane of substrate 130 to a first thickness T1, and a film may be formed. In this case, annealing may be performed at 800°C or more, thereby forming a preliminary ferromagnetic layer 145P of NiO having a (110) crystal plane from the (110) crystal plane of substrate 130. The first thickness T1 may be formed to be approximately 30 nm, but example embodiments thereof are not limited thereto. Also, metal oxides such as CoO and MnO may be stacked on a preliminary ferromagnetic layer 145P.

A preliminary nonmagnetic material layer 147P may be formed on the preliminary ferromagnetic layer 145P. The preliminary nonmagnetic material layer 147P may be formed on the entire surface of the preliminary ferromagnetic layer 145P and may be deposited to include tantalum (Ta).

Referring to FIG. 12B, a preliminary magnetic tunnel junction pattern 150P may be formed on the preliminary nonmagnetic material layer 147P.

On the preliminary magnetic tunnel junction pattern 150P, a free layer 152P, a tunnel barrier 154P, and a fixed layer 156P may be stacked in order on the preliminary nonmagnetic material layer 147P.

On the free layer 152P, at least one ferromagnetic material selected from a group consisting of cobalt (Co), iron (Fe), nickel (Ni), palladium (Pd), and platinum (Pt) may be stacked.

The third thickness T3 of the free layer 152P may be 1 nm to 2 nm, for example, 1.4 nm.

On the tunnel barrier 154P, one material selected from a group consisting of magnesium oxide (MgO), aluminum oxide (Al₂O₃), silicon oxide (SiO₂), and boron oxide (B₂O₃) may be stacked on the free layer 152P. The fourth thickness T4 of the tunnel barrier 154P may be 2 nm to 2.5 nm, for example, 2 nm.

The fixed layer 156P may be formed to include a multilayer structure, and may include manganese iron (FeMn), manganese iridium (IrMn), manganese platinum (PtMn), manganese oxide (MnO), manganese sulfide (MnS), telluric acid manganese (MnTe), manganese fluoride (MnF₂), iron fluoride (FeF₂), iron chloride (FeCl₂), iron oxide (FeO), cobalt chloride (CoCl₂), cobalt oxide (CoO), nickel chloride (NiCl₂), nickel oxide (NiO), chromium (Cr), or the like.

When the preliminary magnetic tunnel junction pattern 150P is formed, a first mask pattern ML1 may be formed, and patterning may be performed from the preliminary magnetic tunnel junction pattern 150P to the preliminary antiferromagnetic material layer 145P to have the first width W1.

In this case, patterning of the preliminary antiferromagnetic material layer 145P may be performed such that, when the direction of the (110) crystal plane of the planar surface is viewed in the X-direction, the direction of the pattern may extend in the D1 direction having a first angle θ with respect to the X-direction.

Referring to FIG. 12C, a second mask pattern ML2 may be formed to have a second width W2, and only the preliminary magnetic tunnel junction pattern 150P may be selectively etched from an upper portion.

In this case, a step difference may be formed between the magnetic tunnel junction pattern 150 and the SOT structure 140 due to a difference in the first width W1 and the second width W2.

When a step difference structure, such as in FIG. 12C, is formed, the first lower electrode 141 and the second lower electrode 143 in FIG. 2 may be formed to be disposed on one side surface and the other side surface of the SOT structure 140.

In this case, the upper electrode 160 may be formed together on the fixed layer 156 of the magnetic tunnel junction pattern 150, thereby forming the magnetic memory device ME in FIG. 2.

In summary, a method of manufacturing a magnetic memory device in example embodiments may include: stacking a preliminary antiferromagnetic material layer on a substrate to have a first crystal direction; forming a preliminary nonmagnetic material layer on the preliminary antiferromagnetic material layer; forming a free layer, a tunnel barrier, and a fixed layer on the preliminary nonmagnetic material layer; forming an antiferromagnetic material layer and a nonmagnetic material layer by patterning the preliminary antiferromagnetic material layer and the preliminary nonmagnetic material layer to extend in a first direction having a first angle with respect to the first crystal direction; and forming a first lower electrode and a second lower electrode on both side surfaces of the nonmagnetic material layer.

The substrate may have the first crystal direction.

The first crystal direction may be a (110) crystal plane.

The first lower electrode and the second lower electrode may be spaced apart from one another in the first direction.

The first lower electrode and the second lower electrode may be formed on both side surfaces of the antiferromagnetic material layer and the nonmagnetic material layer, respectively.

The first lower electrode and the second lower electrode may be formed only on both side surfaces of the nonmagnetic material layer. For instance, the first lower electrode and the second lower electrode may not be formed on side surfaces of the antiferromagnetic material layer. For instance, the first lower electrode and the second lower electrode may be formed on an upper surface of the antiferromagnetic material layer.

The substrate may include magnesium oxide, and the antiferromagnetic material layer may include nickel oxide.

The magnetic antiferromagnetic material layer may have a thickness greater than a thickness of the nonmagnetic material layer.

A width in the first direction of the antiferromagnetic material layer may be greater than a width in the first direction of the free layer.

The nonmagnetic material layer may include tantalum.

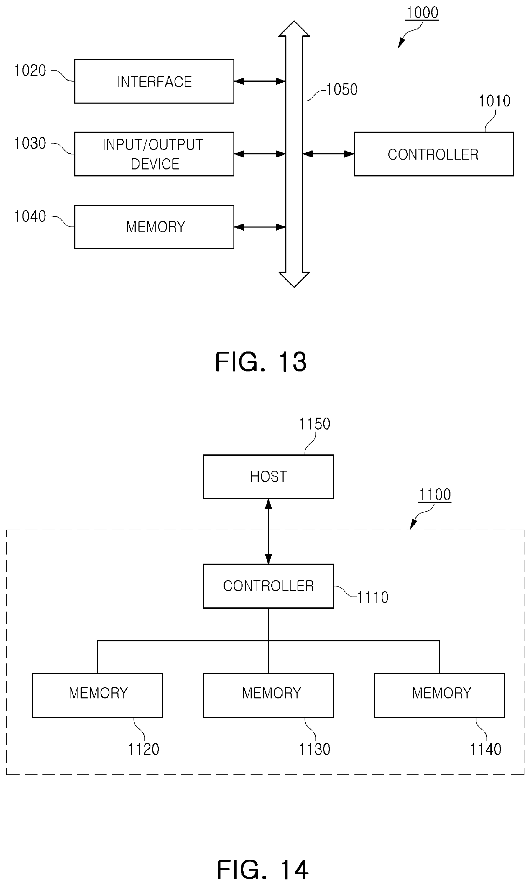

FIGS. 13 and 14 are block diagrams illustrating an electronic device including a magnetic memory device according to example embodiments.

FIG. 13 illustrates an electronic device 1000 including a magnetic memory device according to example embodiments.

Referring to FIG. 13, an electronic device 1000 according to example embodiments may include a controller 1010, an interface 1020, an input/output device 1030, a memory 1040, or the like. The controller 1010, the interface 1020, the input/output device 1030, and the memory 1040 may be connected to one another through a bus WL0 and BUS, which provides a path through which data transfers.

The controller 1010 may include elements such as at least one microprocessor, a digital signal processor, a microcontroller, or the like. The memory 1040 may include elements for reading and writing data in various manners, and the controller 1010 and the memory 1040 may include one of the magnetic memory devices in various example embodiments described with reference to FIGS. 1, 2, 3, 4, 5A, 6A, 6B, 6C, 7A, 7B, 10, and 11.

The input/output device 1030 may include a keypad, keyboard, touchscreen device, display device, audio input/output module, or the like. The interface 1020 may be a module for transmitting and receiving data through a communications network and may include an antenna, a wired/wireless transceiver, or the like. In addition to the components illustrated in FIG. 15, the electronic device 1000 may further include an application chipset, an image capture device, or the like. The electronic device 1000 illustrated in FIG. 13 is not limited to any particular example, and may include various devices such as a personal digital assistant (PDA), a portable computer, a mobile phone, a wireless phone, a laptop computer, a memory card, a portable media player, a tablet PC, or the like.

FIG. 14 is a block diagram illustrating a storage device 1100 including a magnetic memory device according to example embodiments of an embodiment.

Referring to FIG. 14, the storage device 1100 according to example embodiments may include a controller 1110 communicating with a host 1150 and memories 1120, 1130, and 1170 storing data. The controller 1110 and each of the memories 1120, 1130, and 1170 may include a magnetic memory device according to various example embodiments described above with reference to FIGS. 1, 2, 3, 4, 5A, 6A, 6B, 6C, 7A, 7B, 10, and 11.

The host 1150 communicating with the controller 1110 may be implemented as various electronic devices including the storage device 1100, such as a smartphone, a digital camera, a desktop, a laptop, a media player, or the like. The controller 1110 may receive a data write or read request transferred from the host 1150 and may generate a command (CMD) to store data in the memories 1120, 1130, and 1170, or to read out data from the memories 1120, 1130, and 1170.

As illustrated in FIG. 13, one or more memories 1120, 1130, or 1170 may be connected to one another in parallel to the controller 1110 in the storage device 1100. By connecting the plurality of memories 1120, 1130, or 1170 to the controller 1110 in parallel, the storage device 1100 having a relatively large capacity may be implemented.

According to the aforementioned example embodiments, a magnetic memory device may include a nonmagnetic material layer between an antiferromagnetic material layer and a free layer, such that a spin current from the antiferromagnetic material layer may induce magnetization switching of the free layer by a switching current flowing in the nonmagnetic material layer. Accordingly, the spin-orbit torque generated from the antiferromagnetic material layer may be sufficiently generated in the vertical direction to induce the magnetization switching of the free layer, enabling the magnetization switching of the free layer even with a weak current. Accordingly, the reversal may be sufficiently performed with only a weak current without an external magnetic field, such that memory reliability may be ensured.

Also, by calculating an optimal element pattern angle for generating spin-orbit torque as above, the spin-orbit torque generated by the crystal direction of the antiferromagnetic material layer in response to the applied weak current may be ensured.

Embodiments are set out in the following Clauses:
Clause 1. A magnetic memory device, comprising:
   a substrate;
   a spin-orbit torque structure including an antiferromagnetic material layer having a first crystal plane on the substrate and a nonmagnetic material layer on the antiferromagnetic material layer, and patterned in a first direction to have a first angle with respect to the first crystal plane;
   a magnetic tunnel junction pattern including a free layer, a tunnel barrier, and a fixed layer on the spin-orbit torque structure;
   a first lower electrode and a second lower electrode spaced apart from one another in the first direction and disposed on both side surfaces of the spin-orbit torque structure; and
   an upper electrode disposed on the magnetic tunnel junction pattern,
   wherein the first angle is 45 degrees to 90 degrees.
Clause 2. The magnetic memory device of Clause 1, wherein the substrate includes magnesium oxide.
Clause 3. The magnetic memory device of Clause 1 or Clause 2, wherein the substrate has a (110) crystal plane, and the antiferromagnetic material layer has a (110) crystal plane.
Clause 4. The magnetic memory device of any preceding Clause,
   wherein:
   the antiferromagnetic material layer includes nickel oxide, and
   the nonmagnetic material layer includes tantalum.
Clause 5. The magnetic memory device of any preceding Clause,
   wherein:
   the antiferromagnetic material layer has a thickness of 30 nm to 45 nm, and
   the nonmagnetic material layer has a thickness of 3 nm to 5 nm.
Clause 6. The magnetic memory device of any preceding Clause, wherein the first lower electrode and the second lower electrode are in contact with side surfaces of the antiferromagnetic material layer and the nonmagnetic material layer on the substrate.
Clause 7. The magnetic memory device of any preceding Clause, wherein the first lower electrode and the second lower electrode are in contact with only a side surface of the nonmagnetic material layer on the substrate.
Clause 8. The magnetic memory device of any preceding Clause, wherein the magnetic memory device has switching of the free layer in a magnetization direction without an external magnetic field.
Clause 10. A magnetic memory device, comprising:
   a metal oxide pattern having a first crystal plane;
   an antiferromagnetic material layer having the first crystal plane on the metal oxide pattern and extending in a first direction inclined with respect to the first crystal plane;
   a nonmagnetic material layer extending in the first direction on the antiferromagnetic material layer;
   a magnetic tunnel junction pattern including a free layer, a tunnel barrier, and a fixed layer on the nonmagnetic material layer; and
   a first lower electrode and a second lower electrode spaced apart from one another in the first direction, disposed on both side surfaces of the nonmagnetic material layer, respectively,
   wherein a direction of the first crystal plane and the first direction form a 45 degrees to 90 degrees angle.

While the example embodiments have been illustrated and described above, it will be configured as apparent to those skilled in the art that modifications and variations could be made without departing from the scope of the present disclosure as defined by the appended claims.

## Claims

1. A magnetic memory device, comprising:
a substrate (130);
a spin-orbit torque structure (140) including an antiferromagnetic material layer (145) and a nonmagnetic material layer (147) on the substrate (130);
a magnetic tunnel junction pattern (150) including a free layer (152), a tunnel barrier (154) and a fixed layer (156) on the spin-orbit torque structure (140); and
a first lower electrode (141) disposed on one side surface of the spin-orbit torque structure (140) and a second lower electrode (142) disposed on another side surface of the spin-orbit torque structure (140),
wherein a first direction (D1) from the first lower electrode (141) to the second lower electrode (142), parallel to an upper surface of the substrate (130), has an inclination with a crystal direction of a crystal plane of the antiferromagnetic material layer (145).

2. The magnetic memory device of claim 1, wherein the spin-orbit torque structure (140) extends in the first direction (D1).

3. The magnetic memory device of claim 1 or claim 2, wherein a first angle formed by the crystal direction of the crystal plane of the antiferromagnetic material layer (145) and the first direction (D1) is 45 degrees to 90 degrees.

4. The magnetic memory device of any preceding claim,
wherein:
the substrate (130) includes metal oxide, and
a crystal plane of the substrate (130) is the same as the crystal plane of the antiferromagnetic material layer (145).

5. The magnetic memory device of any preceding claim, wherein the nonmagnetic material layer (147) includes tantalum.

6. The magnetic memory device of any preceding claim, wherein the antiferromagnetic material layer (145) includes nickel oxide.

7. The magnetic memory device of claim 6, wherein a thickness of the antiferromagnetic material layer (145) is greater than a thickness of the nonmagnetic material layer (147).

8. The magnetic memory device of claim 7, wherein the thickness of the antiferromagnetic material layer (145) is 30 nm to 45 nm.

9. The magnetic memory device of claim 6 or claim 7, wherein:
the nonmagnetic material layer has a thickness of 3 nm to 5 nm.

10. The magnetic memory device of any preceding claim,
wherein:
an upper surface of the antiferromagnetic material layer (145) is in direct contact with a lower surface of the nonmagnetic material layer (147), and
an upper surface of the nonmagnetic material layer (147) is in direct contact with a lower surface of the free layer (152).

11. The magnetic memory device of any preceding claim, wherein the free layer (152) has a magnetization direction perpendicular to the upper surface of the substrate (130).

12. The magnetic memory device of claim 11, wherein a spin current from the antiferromagnetic material layer (145) switches the magnetization direction of the free layer.

13. The magnetic memory device of any preceding claim, wherein:
the antiferromagnetic material layer (145) has a first crystal plane;
the nonmagnetic material layer (147) is on the antiferromagnetic material layer (145); and
the spin-orbit torque structure (140) is patterned in the first direction (D1) to have a first angle with respect to the first crystal plane, wherein the first angle is 45 degrees to 90 degrees.

14. The magnetic memory device of any preceding claim, wherein the substrate (130) includes magnesium oxide.

15. The magnetic memory device of any preceding claim, wherein the substrate
(130) has a (110) crystal plane, and the antiferromagnetic material layer (145) has a (110) crystal plane.
